# EUROPEAN PATENT APPLICATION

(11) **EP 2 302 691 A1**
(43) Date of publication of application: **30.03.2011**
(21) Application number: 09757641.7
(22) Date of filing: 29.05.2009
(51) Int. Cl.: H01L 31/042, H01L 31/06

(54) **METHOD FOR PRODUCING INTERMEDIATE-BAND DEVICES USING THIN FILM**

(30) Priority: 06.06.2008 ES 200801711
(71) Applicant: Universidad Politécnica De Madrid, 28040 Madrid (ES)
(72) Inventor: FUERTES MARRÓN, David, E-28040 Madrid (ES); MARTÍ VEGA, Antonio, E-28040 Madrid (ES); LUQUE LÓPEZ, Antonio, E-28008 Madrid (ES)
(74) Representative: ABG Patentes, S.L.
(86) International application number: PCT/ES2009/000301
(87) International publication number: WO 2009/147262

(57) **Abstract**

Method for manufacturing of optoelectronic devices based on thin-film, intermediate band materials, **characterized in that** it comprises, at least, the following steps:
- a first stage wherein a substrate (1) is coated with a metal layer acting as electrode (2);
- a second stage, whereby atop the metal layer (2) a p-type semiconductor (3) is deposited; and
- a third stage, whereby the intermediate band material is processed;

and wherein such an intermediate band material comprises nanoscopic structures (4) of multinary material of the type (Cu,Ag)(AI,Ga,In)(S,Se,Te)₂ embedded in a matrix (5) of a similar composition, except for the absence of, at least, one cationic species present in the nanostructure.

## Description

### FIELD OF THE INVENTION

The present invention refers to a method for manufacturing of a type of opto-electronic device, which is based on the characteristic properties of intermediate band materials and adapted for its realization utilizing technological processes devised for thin-film technologies, with particular emphasis on multinary materials of the chalcopyrite type.

### PRIOR ART

Commercial photovoltaic solar cells can be classified into three main categories, according to their manufacturing technologies. The so-called first-generation technology, currently dominating the PV-market, refers to wafer-based solar cells, typically single- or multi-crystalline silicon, as well as single-junction solar cells based on III-V semiconducting compounds (e.g. GaAs, InP, etc.). This type of technology is highly material-demanding: either for an efficient absorption of electromagnetic (EM) radiation, like in silicon solar cells; or else due to the mere requirement of a solid and manageable substrate for subsequent processing. A significant fraction of the overall production cost of this technology is thus simply associated to the material requirements.

As the photovoltaic industry targets a permanent reduction of production costs with the aim of achieving grid parity in the final price of electricity generation with conventional, non-renewable sources, alternative strategies circumventing the massive material requirement of wafer-based technology have been studied. This is the origin of the so-called second generation photovoltaics, which pursues a reduction of production costs as compared to wafer-based technologies by significantly reducing the material demand necessary for the production of devices, while maintaining reasonable figures of energy conversion efficiency. Thin-film technologies (commonly used as an alternative term when referring to second-generation devices) comprise three main types of semiconducting materials (namely amorphous silicon, chalcopyrites and cadmium telluride), which are characterized by a reduction of typically two orders of magnitude of the thickness of the semiconductor material present in the cells, when compared to first-generation (2-3 µm vs. 200-300 µm), having demonstrated efficiency figures of 20% at laboratory scale and above 13% at industrial production in the case of chalcopyrite-based devices.

Both first- and second generation photovoltaics devices are characterized by a common maximum theoretical efficiency of energy conversion, which is determined by the principle of detailed balance. Notwithstanding, cells belonging to the third generation are able to surpass such a theoretical limiting efficiency by, e.g., taking advantage of photons whose energy lies below the bandgap, or forbidden energy range, of the semiconductor material.

Among the schemes proposed in the frame of the third generation photovoltaics, it is worth mentioning that based on intermediate band materials (IBM, US6444897), which are characterized by the presence within the bandgap of a conventional semiconductor material of a partially filled band. The main consequence associated to the presence of such a band of additional electronic states is the ability of promoting electronic transitions from the valence to the conduction band by photons of energies lower than the bandgap (A. Luque and A. Martí, Physical Review Letters 78, 5014-5017, 1997). The energy threshold of the photons capable of inducing such sub-bandgap transitions is determined by the relative position of the intermediate band with respect to the band edges of the valence and conduction bands of the IBM.

Among the approaches proposed for the realization of IBMs it is worth mentioning the introduction of quantum dots into a semiconducting matrix made of a different material. The matrix material must have a bandgap larger than that of the material used for the quantum dots. A set of confined electronic states associated to the quantum dots appear at energy values corresponding to the forbidden energy range of the matrix material, which is a necessary condition for the formation of an intermediate band, referred to the matrix material. The need for achieving the highest light absorption within the smallest material volume possible translates into a requirement of assuring a sufficient density of quantum dots (being, by definition, nanoscopic structures). Additional issues refer to the conditions for half-filling of the confined electronic states.

The practical realization of intermediate band optoelectronic devices based on the utilization of quantum dots has been reported in the literature (A. Luque, A. Martí, N. López, E. Antolín, E. Cánovas, C. R. Stanley, C. Farmer, and P. Díaz, "Operation of the intermediate band solar cell under nonideal space charge region conditions and half filling of the intermediate band," Journal of Applied Physics, vol. 99, p. 094503, 2006). Such devices are based, almost without exception, on the epitaxial growth of semiconducting layers of III-V materials (e.g., GaAs, InP, etc.). A common feature of these methods of manufacturing is the fact that the growth of the nanostructures follows the Stranski-Krastanov mode, in which the quantum dots stem from a thin wetting layer with a quantum well structure. As a result, this type of growth leads to hybrid structures combining areas of one- (quantum wells) and three-dimensional electronic confinement (quantum dots). This type of growth, though commonly found, is not optimal for the manufacturing of the intended nanostructures, which would require complete three-dimensional confinement.

Additionally, the epitaxial growth, which is necessary to ensure a sufficient control over the manufacturing of III-V-based structures, is costly both in economical and temporal terms. Therefore, such an approach would hardly support the desired cost reduction of photovoltaic production intended for third-generation devices.

It is in this frame where the present proposal is intended to contribute, whereby a manufacturing method and a process thereof for the realization of intermediate band solar cells and optoelectronic devices is proposed, based on a simple technological process like the one described in the german patent PCT/DE2007/002230 (also international), which permits the implementation of quantum dots based on materials of interest in thin-film technologies. The technological maturity achieved by photovoltaic thin-film technologies nowadays represents and added value to the method described, whereby the technical processes involved in the proposal can be easily transferred and incorporated into production lines, should the proposed combination of second- and third-generation elements be of practical interest. To clarify this point further we will now briefly summarize the main features of the processes described and their proposed adaptation to the manufacturing of IBMs thereof.

Although chalcopyrites have been grown and studied in the form of nanostructures produced from a variety of techniques well described in the literature, hardly any of such methods can be easily incorporated into procedures leading to optoelectronic devices as required for the operation of IBMs. For such a purpose, it is mandatory to implement nanostructures embedded into a semiconducting matrix, and not just as isolated nanocrystals. The method described by Fuertes Marrón et al. (DE 102006060366.4-43, Phys. Rev. B 77, 085315, 2008) suggests a way of realizing semiconductor hetero-strucutres similar to those proposed for the realization of IBM-based devices based on III-V compounds, in which quantum dots are implemented into a barrier material in a single sequential process. For this goal, starting with a substrate (metal, semiconductor or insulator), a number of nanoscopic metallic precursors, either elemental or in the form of alloy compounds, containing species to be incorporated into the final compound [e.g., Cu, Ga or CuGa for the case of the growth of CuGaS₂, CuGaSe₂, CuGaTe₂, or CuGa(S,Se,Te)₂], are deposited onto it. The deposition of the metallic precursors is a fast and easy process, which can be carried out at atmospheric pressure (e.g., by electrodeposition), at ambient temperature (sputtering) or under more or less sophisticated combinations of different parameters, with the condition of providing a sufficient density of structures per unit area onto the substrate but not forming a complete coating onto it. Control over the size and distribution of metallic precursors is of paramount importance, as these parameters will determine the size and distribution of the final semiconducting nanostrucutres. The subsequent exposure of such metallic precursors to an atmosphere containing the rest of the species to be incorporated into the compound under favorable conditions of temperature and pressure (e.g., by means of chemical vapor transport or evaporation), will result in a series of ternary or multinary semiconducting nanostructures embedded into a different semiconducting material, typically a binary or multinary compound, which will be deposited as to ensure a complete coating of both the substrates and the nanostructures, and in which the elements previously deposited in the form of precursors will be absent. The electronic structure of the materials considered will be characterized by a reduction of the bandgap (range of energies without allowed electronic states) in the nanoscopic structures as compared to the corresponding value of the barrier material. As a result, a thin film is obtained with a final thickness ranging typically between ten to hundreds of nanometers, depending on the deposition process and the operating parameters used, which will be characterized by the presence of a number of metallurgical and electronic hetero-structures between dissimilar materials, namely chalcopyrite quantum dots embedded into a semiconducting matrix.

### DESCRIPTION OF THE INVENTION

The present invention refers to the manufacturing of optoelectronic devices based on thin-film IBMs, starting from a manufacturing procedure of nanoscopic structures of multinary compounds of the chalcopyrite type, e.g., (Cu,Ag)(Al,Ga,In)(S,Se,Te)₂ and derivatives obtained from deviations in the stoichiometry, the so-called I-III₃-VI₅ and I-III₅-VI₈ compounds, as described before (DE 102006060366.4-43, Phys. Rev. B 77, 085315, 2008). According to the referred procedure, it is possible to embed nanoscopic structures inside a semiconducting matrix in a single technological process, resulting in an IBM. The novelty of the design lies in the incorporation of such a procedure into the typical processing sequence of thin-film devices, by which thin-film intermediate band solar cells can be obtained.

This structure is formally analog to that described in the literature as an IBM obtained from epitaxial growth of III-V compounds. However, the method proposed has a number of advantages, which will be detailed in the next lines:
- Flexibility regarding material systems, whose properties are easily adjustable by means of composition control; the variation of stoichiometry of components in compounds of the type I-III-VI2, like (Cu,Ag)(Al,Ga,In)(S,Se,Te)₂, leads to solid solutions with variable physical properties, like the energy gap (1.0 eV for CuInSe₂, 3.5 eV for CuAIS₂);
- Relaxation of criteria concerning the choice of materials for the realization of hetero-structures linked to the deviation of lattice parameters (lattice mismatch; firstly, because the tension associated to the formation of nanostructures, driving the growth in the Stranski-Krastanov mode, is not determinant to the type of growth hereby proposed; and secondly, because of the high tolerance shown by these materials to defects in the crystal lattice, either in the bulk or at the surfaces.
- Relaxation of requirements of epitaxial growth, which imply time consuming and costly processes; I-III-VI₂ chalcopyrite materials, as used for optoelectronic devices, are typically microcrystalline. Particularly, solar cells fabricated with microcrystalline material out of such compounds outperform both in electronic quality and energy conversion efficiency their single-crystalline counterparts. In fact, the determinant role played by grain boundaries on the electronic transport properties in these compounds is a subject of current study.
- Relaxation of requirements of ultra-high vacuum (UHV) processing, typically associated with a large fraction of epitaxial systems, like molecular beam epitaxy (MBE), although with exceptions (like metal-organic chemical vapor deposition, MOCVD). The case of study of Fuertes Marrón et al. (DE 102006060366.4-43, Phys. Rev. B 77, 085315, 2008) refers to the growth by chemical transport at a typical pressure of 100-800 mbar.
- Real three-dimensional electronic confinement at the nanostructures, without the need of depositing closed wetting layers inducing the Stranski-Krastanov mode of the quantum-dot growth.

In light of what has been described hitherto, it is proposed to use microcrystalline materials of the type I-III-VI₂ chalcopyrites for the realization of IBMs, following the procedure described by Fuertes Marrón et al. (DE 102006060366.4-43, Phys. Rev. B 77, 085315, 2008) and adapted in a way, which is described in detail in what follows:
A metal layer, acting as an electrode, is deposited onto a given substrate, either rigid (typically glass), or flexible (a thin metal or plastic foil). The metal must withstand the subsequent processing steps carried out under reactive, chalcogen-containing atmospheres. Molybdenum (Mo) is the typical electrode used as a contact in thin-film technology. A p-type semiconductor, e.g., CuGaS₂, with a non-critical, typical thickness of ∼1 micrometer, is deposited onto the metal layer. The processing of the IBM follows, consisting in nanoscopic structures of multinary material of the type (Cu,Ag)(AI,Ga,In)(S,Se,Te)₂ embedded into a matrix material of a similar composition, except for the absence of one or more cationic species, which are present into the nanostructures. The choice of appropriate compounds will be in accordance to the energy range of interest of the solar spectrum and to the operation conditions foreseen, e.g., if operated under concentrated light or not. As an example, CuGaSe₂ (Eg=1.7 eV) nanostructures embedded into Ga₂Se₃ matrix (Eg=2.4 eV) could be contemplated as a material system to operate under typical standard AM1.5G spectrum.

The manufacturing of the IBM in the form of a thin film will be detailed now. Starting from the nanoscopic metallic precursors deposited onto a substrate, typically a semiconductor, highly structured material at nanometric scale will be obtained after exposing the precursors to an atmosphere, which contains all other elements expected to form the final compound (the chalcogens and metallic species not included in the precursors). Lateral variations in the chemical potential of the different species involved in the chemical reactions and deposition into the solid phase, which are associated to the presence of a distribution of finite metallic precursors on the sample, will ultimately lead to two main different types of reactions into the solid phase, provided the processing parameters (temperature and pressure) are appropriate: on the one hand, the reaction of species in the gas phase with elements contained in the precursors at those places where the latter are present; and on the other hand, the condensation into the solid phase of the species contained in the atmosphere, not assisted by precursors, at those places of the substrate where precursors are absent. The result of the process is a thin film of variable thickness, typically in the range of 10-1000 nm, which is characterized by the presence of metallurgical and electronic heterostructures between dissimilar semiconductor materials, whose number and distribution are determined by the number and distribution of the original precursors. The procedure can be carried out in a cyclic fashion, piling up a number of layers that may result in the electronic coupling between nanostructures, both in the plane parallel to the substrate and in the perpendicular to it (between layers). Such a structure shows electronic properties as those described for intermediate band materials (IBMs) and, therefore, the method hereby proposed is contemplated as a feasible way for the manufacturing of IBMs based on multinary compounds of the type I-III-VI₂ and related ones.

The absence of one or more cationic species in the barrier material introduces abrupt steps in the associated band diagram of the resulting material, which are localized at the interfaces between dissimilar compounds of three-dimensional-nature, in bulky structures. The offsets at valence, conduction, or both bands of both materials will depend on the materials chosen and can, in first approximation, be predicted following Anderson's rule, as a function of the electron affinities. The processing method of this IBM follows the one described in DE 102006060366.4-43, Phys. Rev. B 77 085315, 2008, utilizing the same growth method (UHV, sputtering, evaporation, chemical transport, etc.) as used for the deposition of the preceding semiconductor layer, i.e., without solution of continuity. The formation of the nanostructures follows from the local reaction of the metallic precursors of nanoscopic dimensions with the reactive components, which, in the absence of any precursor, will form the matrix compound. It is thus a sequential growth: 1^{st} deposition of the precursor; 2^{nd} deposition of reactives, with the reaction taking place during the second step, at a sufficient temperature. Such a sequence can be repeated for a number of cycles, increasing the volume density of the nanostructures as the semiconducting matrix material keeps on growing to a thickness in the range 1-5 micrometers.

The rest of the structure consists of layers, which are processed in analogous fashion as in a conventional chalcopyrite-based thin-film technology, comprising a 50-100 nm thick buffer layer, typically CdS, InS, ZnS, ZnSe, In(S,OH), Zn(S,OH), Zn(Se,OH) or similar, grown either by the same method as the preceding layers, or else ex-situ by chemical bath, spin-coating, ILGAR, etc. The n-type semiconductor consists of a transparent conducting oxide (TCO, typically ZnO), usually in the form of a double layer (undoped+doped), after which the deposition of a front contact through a mask follows, usually evaporating Ni-Al grids.

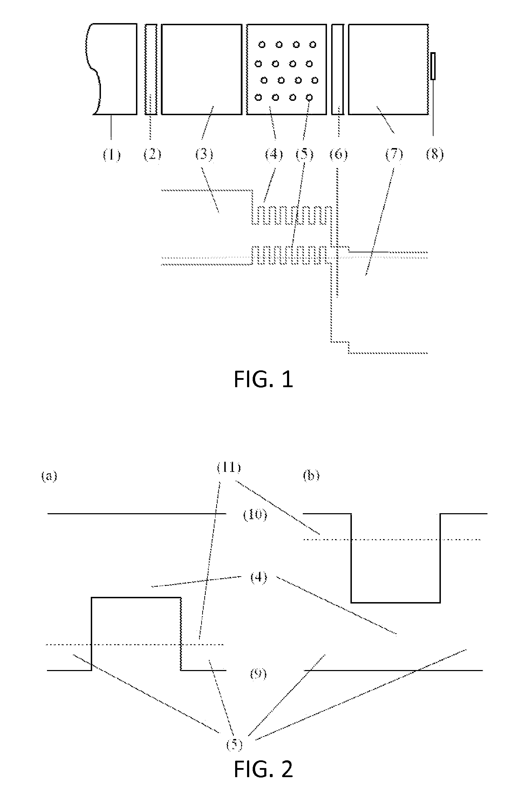

Regarding the energy band alignment of the active layer of the device, i.e., in the IBM, different options are contemplated. The theoretical work reported on the topic predicts an analogue behavior regarding optoelectronic properties in those cases in which the position of the intermediate band is located closer to the conduction than to the valence band, or alternatively, closer to the valence than to the conduction band, existing in either case an optimal energy distance relative to the closest band edge, as a function of the gap of the matrix material. The resulting heterojunctions formed by the ternary or multinary nanostructures in the barrier material introduce localized discontinuities in the corresponding band diagram. There are discontinuities affecting only one band, either the conduction or the valence band. The election of either case will be determined by the type of material chosen for the nanostructures and the matrix, as a function of their electron affinities (being, e.g., different for the case of sulfide and selenide compounds, and within each family, different depending on the group-I and group-III contents). Deciding on one type of material or the other will be in turn largely determined by its electronic transport properties particularly by the mobility of minority carriers in the matrix material, which can favor in practice the selection of a p- or n-type material, although such a distinction at a theoretical level is irrelevant. In any case, the magnitude of the discontinuity in the energy axis of the band diagram can be optimized by means of the composition and the size of the nanostructures, in such a way that the confined electronic states may appear at the optimal energetic positions as predicted for the intermediate band. The design is thus forgiving under certain conditions of electronic design detailed below. Although the theoretical model of IBMs does not contemplate the presence of additional electronic states in the bandgap of the matrix material, other than those forming the intermediate band, in the case of chalcopyrite-based compounds and others (e.g., spinels, etc.) the presence of native point defects in the crystalline lattice is abundant and, in many cases, determinant with regard to their optoelectronic properties. There is, nevertheless, one particular aspect, which is worth mentioning when referring to their potential utilization for IBMs, namely, the control of the position on the energy axis of the demarcation level associated to some of these defects. It is known that native defects (mainly vacancies, anti-sites and localized combinations of both) may limit the ability to dope some of these materials, especially the so-called wide-gap ones (Eg>1.5 eV). The self-compensation mechanism is triggered by spontaneous (exothermic) formation of defects, which introduce either donor or acceptor states as a function of the position of the Fermi level within the bandgap. When the position of the Fermi level varies (e.g., by doping), approaching one of the band edges of the material, the self-compensation mechanism acts forming compensating native defects spontaneously and counteracting the action of the dopants, either native or extrinsic, limiting the displacement of the Fermi level within the demarcation limit. It is important to point out that the demarcation level is not necessarily associated to an existing of electronic states at that particular energy value. Such a situation is described in terms of Fermi-level pinning, which in practice means that there will exist intrinsic limits, generally different from the mere bandgap value, as considered in the theoretical model of the intermediate band, to the magnitude of the splitting of quasi-Fermi levels when the material is out of equilibrium, e.g., under illumination. This fact in turn implies the existence of maximum theoretical values of expected open-circuit voltage and, therefore, of the tension that the solar cell based on these materials could deliver. Should these values of the output voltage (or in other words, the splitting of quasi-Fermi levels) be sufficient for the manufacturing of a conventional useful device, so would it be also for the case of implementing an IBM into them. Regarding this last point, these considerations introduce constraints with regard to the magnitudes of the band discontinuities associated to the hetero-junctions formed between the nanostructures and the matrix material. In other words, the minimum band offset and, therefore, the favorable position on the energy axis of the electronic states associated to the intermediate band will be ultimately determined by the situation of the demarcation levels of the matrix compound. By the same argument, band diagrams as the one shown in Figure 1 will be acceptable if the magnitude of the discontinuity in the bands associated to the hetero-structure is larger than the energy difference between the demarcation levels and the edge of the closest band in the matrix material.

### EXPLANATON OF THE DRAWINGS

In the following, a set of drawings will be briefly described that may help a better comprehension of the invention and which are related explicitly with its realization as a means of a non-limitative example.
- Figure 1.: Schematic structure of a thin-film photovoltaic device based on hetero-structures including an intermediate band material, sequence of its manufacturing and associated band diagram. (1) Substrate, (2) rear electrode, (3) p-type semiconductor, (4) nanoscopic structures or quantum dots, (5) matrix material, (6) buffer layer, (7) n-type semiconductor, and (8) front electrode.
- Figure 2. (a): Band diagram associated to a nanostructure of ternary or multinary compound, which is embedded into a binary or multinary matrix, showing a discontinuity at the valence band. (b) Idem, with a discontinuity at the conduction band. (4) Nanoscopic structure or quantum dots, (5) matrix material, (9) valence band, (10) conduction band, and (11) demarcation levels.

### DETAILED DESCRIPTION OF PREFERRED EMBODIMENTS

As it can be observed in the attached figures, the manufacturing method of intermediate band optoelectronic devices based on thin-film technology, the matter of the present application, comprises, at least, the following stages:
- a first stage, in which a metal layer (2), to act as an electrode, is deposited onto a substrate (1), which can be either rigid or flexible, typically glass in the case of rigid structures and metal or plastic foil for flexible structures.
- a second stage, in which a p-type semiconductor layer (3) is deposited onto the metal layer resistant to reactive, chalcogen-containing atmospheres, typically Molibdenum;
- and a third stage of processing of the intermediate band material;
   wherein an intermediate band material comprises nanoscopic structures (4) made of a multinary material of the type (Cu,Ag)(AI,Ga,In)(S,Se,Te)₂ embedded into a matrix (5) of similar composition, except for the absence of, at least, one cationic species present in the nanostructure.

The intermediate band material is to be based, e.g., on nanostructures of CuGaSe₂ embedded into Ga₂Se₃. Additionally, the p-type semiconductor (3) consists of CuGaS₂ of a non-critical thickness up to one micrometer.

The absence of, at least, one cationic species in the matrix material (5) produces abrupt changes (hetero-junctions) in the band diagram of the resulting material, which are localized at the junctions between dissimilar materials, represented schematically in Figure 1 as quantum wells in one dimension, although of three-dimensional nature in bulky structures; and where the band offsets at conduction-, valence- or both band-edges between both materials will depend on the selection of the latter and their electron affinities.

The formation of the nanostructures follows the local reaction of the nanoscopic metal precursors with the reactive material, which in the absence of precursor species will form the matrix material. The procedure is thus a sequential growth process: 1^{st} deposition of precursor; 2^{nd} deposition of reactants, whereby the reaction will proceed during the second stage at sufficient temperature. Such a sequence can be repeated for a number of cycles, leading to higher volumetric densities of the nanostructures as the growth of the matrix material proceeds, until reaching a thickness within 1-5 micrometers range.

The remaining structure consists of the deposition layers, which are processed in an analogue fashion as for thin-film chalcopyrite material technology, including: a buffer layer (6), typically CdS, InS, ZnS, ZnSe, In(S,OH), Zn(S,OH), Zn(Se,OH) or similar, with a thickness between 50-100 nm and deposited either in-situ by the same growth method as the previous layers or else ex-situ by chemical bath, spin coating, ILGAR, etc.; the n-type semiconductor (7) consists of a transparent conducting oxide (TCO, typically ZnO), generally in a double layer (undoped+doped), after which the deposition of the metallic front contact (8) proceeds through a mask, generally deposited by evaporation of Ni-Al grids.

Figures 1 and 2 represent the cases in which the heterostructures formed by the nanoscopic structures of a ternary or multinary material inside the matrix material introduce localized discontinuities in the corresponding band diagram. Figure 2 shows examples of discontinuities affecting only one of the bands, either the valence (9) or conduction (10) band (Figures 2a and 2b, respectively). The choice of either case will be determined by the type of material chosen for the nanostructures (4) and the matrix (5), as a function of their electron affinities (being,e.g., different for the cases of sulfide or selenide compounds and, within each species, different according to the contents of elements of groups I and III). Choosing one type of material or another will be largely determined in turn by the electronic transport properties, and particularly by the mobility of minority charge carriers in the matrix compound (4), which in practice may favor the selection of an p- or n-type material, although such a distinction, at a theoretical level, be irrelevant. In any case, the magnitude of the discontinuity at the energy axis in the band diagram can be optimized by means of composition and size of the embedded nanostrucutres, in such a way that the confined electronic states may show up at optimal energetic positions, as predicted by the theory of the intermediate band. In Figure 1, the band discontinuities affect both the valence and conduction band. Such a design could be acceptable under certain conditions that will be detailed in the following. Although the theoretical framework of the intermediate band does not contemplate the presence of additional electronic states within the bandgap of the matrix material, apart from those building up the intermediate band, in the case of chalcopyrite materials and others (like, e.g., spinels, etc.) it is the presence of abundant native point defects in their crystalline structure that determines to a large extent their opto-electronic properties. One particular aspect that is worth mentioning when referring to the eventual utilization of these type of materials as intermediate band material candidates is the control over the position of the demarcation levels (11) associated to some of these defects. It is known that native defects (mostly vacancies, anti-sites, and localized combinations of both) can limit the doping capability in some of these compounds, and particularly those with larger bandgaps (Eg>1.5 eV). The self-compensation mechanism is regulated by spontaneous (exothermic) formation of defects introducing acceptor or donor levels, which is in turn a function of the position of the Fermi level inside the bandgap). When the Fermi level position varies (e.g., by doping), getting closer to one of the band edges, the self-compensation mechanism will be active, leading to spontaneous formation of native defects compensating those, either extrinsic or intrinsic, being utilized as dopants, and limiting the movement of the Fermi level beyond the demarcation limit. It should be pointed out that the demarcation limit is not necessarily associated to the existence at that particular energy of any allowed electronic state. Such a situation is described by Fermi level pinning, and, in practice, means that there will exist intrinsic limits, generally distinct from the mere energy bandgap of the material, as considered in the intermediate band theory, to the splitting of the quasi-Fermi levels whenever the material is operating out of equilibrium, e.g., under illumination. This fact, in turn, translates into maximum values of the expected open-circuit voltage and thus of the output voltage that a working solar cell based on such a material can provide. If such limiting voltage values (or in other words, splitting of quasi-Fermi levels) were sufficient for the manufacturing of a usable conventional device, so it will be, in principle, for the implementation of an intermediate band material. With regard to this last issue, the above considerations may introduce additional restrictions to the magnitude of the band discontinuities associated to the hetero-junctions between nanostructures and matrix materials. In other words, the minimum band offset, and therefore the position on the energy axis of those electronic states building up the intermediate band, will be ultimately determined by the position of the demarcation levels in the matrix material. By the same argument, band diagrams as the one shown in Figure 1 will be acceptable if the magnitude of the discontinuity at the bands associated to the hetero-junction is larger than the energy difference between the demarcation level and the corresponding closest band edge, as shown in Figure 2.

## Claims

1. Method for manufacturing of optoelectronic devices based on thin-film, intermediate band materials, comprising, at least, the following steps:
- a first stage wherein a substrate (1) is coated with a metal layer (2) acting as electrode;
- a second stage, whereby atop of the metal layer (2) a p-type semiconductor (3) is deposited; and
- a third stage, whereby the intermediate band material is processed;
and wherein such an intermediate band material comprises in nanoscopic structures (4) of multinary material of the type (Cu,Ag)(AI,Ga,In)(S,Se,Te)₂ embedded in a matrix (5) of a similar composition, except for the absence of, at least, one cationic species present in the nanoscopic structure.

2. Method according to claim 1, wherein the substrate (1) is a rigid structure.

3. Method according to claim 2, wherein the substrate (1) is glass.

4. Method according to claim 1, wherein the substrate (1) is a flexible structure.

5. Method according to claim 4, wherein the substrate (1) is a metal or a plastic foil.

6. Method according to claim 1, wherein the metal layer (2) is a material resistant against chalcogen-containing reactive atmospheres.

7. Method according to claim 1, wherein the metal layer (2) is made of Molybdenum (Mo).

8. Method according to claim 1, wherein the intermediate band material is based on structures of CuGaSe₂ embedded into Ga₂Se₃.

9. Method according to claim 1, wherein the p-type semiconducting layer (3) is CuGaS₂ with a non-critical thickness up to 1 µm.

10. Method according to claim 1, wherein the absence of, at least, one cationic species in the matrix material (5) produces abrupt changes (hetero-junctions) in the band diagram of the resulting material, which are localized at the heterojunctions between the dissimilar materials, of three-dimensional nature in bulky structures; and whereby the band offsets at conduction and/or valence bands of both materials will depend on their selection and on their electron affinities.
